# EUROPÄISCHE PATENTSCHRIFT

(11) **EP 0 815 594 B1**
(45) Veröffentlichungstag und Bekanntmachung des Hinweises auf die Patenterteilung: **25.08.1999**
(21) Anmeldenummer: 96905680.3
(22) Anmeldetag: 04.03.1996
(51) Int. Cl.: H01L 27/112, H01L 21/8246

(54) **FESTWERT-SPEICHERZELLENANORDNUNG UND VERFAHREN ZU DEREN HERSTELLUNG**
READ-ONLY STORAGE CELL ARRANGEMENT AND PROCESS FOR ITS PRODUCTION
SYSTEME DE CELLULES DE MEMOIRE MORTE ET SON PROCEDE DE REALISATION

(30) Priorität: 20.03.1995 DE 19510042
(43) Veröffentlichungstag der Anmeldung: 07.01.1998
(73) Patentinhaber: SIEMENS AKTIENGESELLSCHAFT, 80333 München (DE)
(72) Erfinder: KRAUTSCHNEIDER, Wolfgang, D-83104 Hohenthann (DE); RISCH, Lothar, D-85579 Neubiberg (DE); HOFMANN, Franz, D-80995 München (DE)
(86) Internationale Anmeldenummer: DE9600380
(87) Internationale Veröffentlichungsnummer: WO9629739

(56) Entgegenhaltungen:
- US-A- 5 306 941

## Beschreibung

Für viele elektronische Systeme werden Speicher benötigt, in die Daten fest eingeschrieben sind. Derartige Speicher werden unter anderem als Festwertspeicher, Lesespeicher oder Read-Only-Memory bezeichnet.

Für sehr große Datenmengen werden als Lesespeicher vielfach Kunststoffscheiben verwendet, die mit Aluminium beschichtet sind. In der Beschichtung weisen diese Kunststoffscheiben zweierlei punktartige Vertiefungen auf, die den logischen Werten Null und Eins zugeordnet werden. In der Anordnung dieser Vertiefungen ist die Information digital abgespeichert. Derartige Scheiben werden als Compaktdisc bezeichnet und sind zur digitalen Abspeicherung von Musik verbreitet.

Zum Lesen der auf einer Compaktdisc gespeicherten Daten wird ein Lesegerät verwendet, in dem die Scheibe mechanisch rotiert. Die punktartigen Vertiefungen werden über eine Laserdiode und eine Photozelle abgetastet. Typische Abtastraten sind dabei 2 x 40 kHz. Auf einer Compaktdisc können fünf GBits Informationen gespeichert werden.

Das Lesegerät weist bewegte Teile auf, die mechanischem Verschleiß unterworfen sind, die vergleichsweise viel Volumen benötigen und die nur einen langsamen Datenzugriff erlauben. Das Lesegerät ist darüber hinaus empfindlich gegen Erschütterungen und daher in mobilen Systemen nur begrenzt einsetzbar.

Zur Speicherung kleinerer Datenmengen sind Festwertspeicher auf Halbleiterbasis bekannt. Vielfach werden diese als planare integrierte Siliziumschaltung realisiert, in der MOS-Transistoren verwendet werden. Die MOS-Transistoren werden jeweils über die Gateelektrode, die mit der Wortleitung verbunden ist, ausgewählt. Der Eingang des MOS-Transistors ist mit einer Referenzleitung verbunden, der Ausgang mit einer Bitleitung. Beim Lesevorgang wird bewertet, ob ein Strom durch den Transistor fließt oder nicht. Entsprechend wird die gespeicherte Information zugeordnet. Technisch wird die Speicherung der Information meist dadurch bewirkt, daß die MOS-Transistoren durch unterschiedliche Implantationen im Kanalgebiet unterschiedliche Einsatzspannungen aufweisen.

Diese Speicher auf Halbleiterbasis erlauben einen wahlfreien Zugriff auf die gespeicherte Information. Die zum Lesen der Information erforderliche elektrische Leistung ist deutlich kleiner als bei einem Lesegerät mit einem mechanischen Laufwerk. Da zum Lesen der Information kein mechanisches Laufwerk erforderlich ist, entfällt der mechanische Verschleiß und die Empfindlichkeit gegenüber Erschütterungen. Festwertspeicher auf Halbleiterbasis sind daher auch für mobile Systeme einsetzbar.

Die beschriebenen Siliziumspeicher weisen einen planaren Aufbau auf. Damit wird pro Speicherzelle ein minimaler Flächenbedarf erforderlich, der bei etwa 6 bis 8 F² liegt, wobei F die in der jeweiligen Technologie kleinste herstellbare Strukturgröße ist. Planare Siliziumspeicher sind damit in einer 1 µm-Technologie auf Speicherdichten um 0,14 Bit pro µm² begrenzt.

Es ist bekannt, bei planaren Siliziumspeichern die Speicherdichte dadurch zu erhöhen, daß die MOS-Transistoren zeilenweise angeordnet sind. In jeder Zeile sind die MOS-Transistoren in Reihe verschaltet. Durch zeilenweises Ansteuern im Sinne einer "NAND"-Architektur werden die MOS-Transistoren ausgelesen. Dazu sind pro Zeile nur zwei Anschlüsse erforderlich, zwischen denen die in der Zeile angeordneten MOS-Transistoren in Reihe verschaltet sind. Miteinander verbundene Source/Drain-Gebiete benachbarter MOS-Transistoren können dann als zusammenhängendes dotiertes Gebiet realisiert sein. Dadurch kann der Flächenbedarf pro Speicherzelle auf theoretisch 4 F² (F: in der jeweiligen Technologie kleinste herstellbare Strukturgröße) reduziert werden. Eine solche Speicherzellenanordnung ist zum Beispiel aus H. Kawagoe und N. Tsuji in IEEE J. Solid-State Circuits, vol. SC-11, p. 360, 1976, bekannt.

Aus US-A-5 306 941 ist eine Festwertspeicherzellenanordnung bekannt, in der in einem Substrat streifenförmige Gräben vorgesehen sind. Die Speicherzellen umfassen jeweils eine MOS-Transistor, dessen Kanallänge quer zu den Gräben ausgerichtet ist.

Der Erfindung liegt das Problem zugrunde, eine Festwert-Speicherzellenanordnung auf Halbleiterbasis anzugeben, bei der eine erhöhte Speicherdichte erzielt wird und die mit wenigen Herstellungsschritten und hoher Ausbeute herstellbar ist. Desweiteren soll ein Verfahren zur Herstellung einer solchen Speicherzellenanordnung angegeben werden.

Dieses Problem wird gelöst durch eine Festwert-Speicherzellenanordnung gemäß Anspruch 1 sowie durch ein Verfahren zu deren Herstellung gemäß Anspruch 5. Weitere Ausgestaltungen der Erfindung gehen aus den übrigen Ansprüchen hervor.

In der erfindungsgemäßen Festwertspeicherzellenanordnung sind Speicherzellen jeweils in im wesentlichen parallel verlaufenden Zeilen in einer Hauptflache eines Halbleitersubstrats angeordnet. In der Hauptfläche des Halbleitersubstrats sind Längsgraben vorgesehen. Die Langsgraben verlaufen im wesentlichen parallel zu den Zeilen. Sie sind mindestens so lang wie die Zeilen. Die Zeilen sind jeweils abwechselnd zwischen benachbarten Langsgraben und auf dem Boden der Langsgraben angeordnet. Die Hauptfläche des Halbleitersubstrats ist durch die Längsgraben strukturiert. Jede zweite der Zeilen ist am Boden der Langsgraben angeordnet, die dazwischen angeordneten Zeilen sind auf dem die Langsgraben begrenzenden Material angeordnet.

Benachbarte Zeilen sind durch eine Isolationsstruktur gegeneinander isoliert. Die Isolationsstruktur isoliert benachbarte Zeilen in vertikaler Richtung. Es liegt im Rahmen der Erfindung, die Isolationsstruktur durch entlang den Seitenwänden der Langsgräben angeordnete, isolierende Spacer und jeweils zwischen benachbarten Langsgraben im Halbleitersubstrat angeordnete, dotierte Schichten, die die Ausbildung leitender Kanäle im Halbleitersubstrat zwischen benachbarten Zeilen verhindern, sogenannte Channel-Stop-Schichten, auszubilden. Die dotierten Schichten sind vorzugsweise in dem Material des Halbleitersubstrats, das jeweils zwischen benachbarten Längsgraben angeordnet ist, ausgebildet und weisen eine Tiefe im Halbleitersubstrat auf, die geringer als die Tiefe der Längsgräben ist. Diese Isolation benötigt zwischen benachbarten Zeilen keine Fläche. Parallel zur Hauptfläche des Halbleitersubstrats sind benachbarten Zeilen unmittelbar zueinander benachbart. Senkrecht zur Hauptfläche des Halbleitersubstrats weisen benachbarten Zeilen einen Abstand entsprechend der Tiefe der Längsgraben auf.

Vorzugsweise sind die MOS-Transistoren von entlang einer Zeile angeordneten Speicherzellen in Reihe verschaltet. Miteinander verbundene Source/Drain-Gebiete von entlang einer Zeile benachbarten MOS-Transistoren sind dabei als zusammenhängendes dotiertes Gebiet ausgebildet. Jede Zeile weist zwei Anschlüsse auf, zwischen denen in der Zeile angeordnete MOS-Transistoren in Reihe verschaltet sind. Über diese Anschlüsse können die in der jeweiligen Zeilen befindlichen MOS-Transistoren im Sinne einer "NAND"-Architektur angesteuert werden.

Vorzugsweise wird die erfindungsgemäße Festwert-Speicherzellenanordnung mit einer Isolationsstruktur, die isolierende Spacer und dotierte Schichten, die die Ausbildung leitender Kanäle im Halbleitersubstrat zwischen benachbarten Zeilen verhindert, umfaßt, sowie mit in jeder Zeile in Reihe verschalteten MOS-Transistoren, in denen jeweils miteinander verbundene Source/Drain-Gebiete als zusammenhängendes dotiertes Gebiet im Halbleitersubstrat ausgebildet sind, realisiert. Werden in dieser Ausführungsform die Breite der Längsgräben, der Abstand benachbarter Längsgräben, die Ausdehnung der zusammenhängenden dotierten Gebiete und die Breite der Wortleitungen entsprechend einem in der jeweiligen Technologie minimalen Strukturgröße F ausgebildet, so beträgt der Flächenbedarf pro Speicherzelle 2 F². Unter Zugrundelegung einer Technologie mit einer minimalen Strukturbreite F von 0,4 µm ist damit eine Speicherdichte von 6,25 Bit/µm² erzielbar.

Es liegt im Rahmen der Erfindung, daß die MOS-Transistoren je nach in der jeweiligen Speicherzelle eingespeicherter Information unterschiedliche Schwellenspannungen aufweisen. Zur Abspeicherung der Daten in digitaler Form weisen die MOS-Transistoren zwei unterschiedliche Schwellenspannungen auf. Soll die Festwert-Speicherzellenanordnung für Mehrwertlogik eingesetzt werden, so weisen die MOS-Transistoren je nach eingespeicherter Information mehr als zwei unterschiedliche Schwellenspannungen auf.

Die Herstellung der erfindungsgemäßen Festwert-Speicherzellenanordnung erfolgt unter Einsatz selbstjustierender Prozeßschritte, so daß der Platzbedarf pro Speicherzelle reduziert werden kann.

Zur Herstellung der Festwert-Speicherzellenanordnung wird zunächst eine erste Kanalimplantation zur Einstellung der Schwellenspannungen der MOS-Transistoren, die entlang zwischen benachbarten Langsgraben angeordneten Zeilen angeordnet sind, durchgeführt. Anschließend erfolgt die Ätzung der Längsgräben. Nach der Ätzung der Langsgraben erfolgt eine zweite Kanalimplantation zur Einstellung der Schwellenspannungen der MOS-Transistoren, die am Boden der Langsgraben angeordnet sind. Bei der zweiten Kanalimplantation sind die Bereiche zwischen benachbarten Langsgraben maskiert. Nach Erzeugung einer Gateoxidschicht für alle MOS-Transistoren werden quer zu den Zeilen verlaufende Wortleitungen erzeugt, die jeweils Gateelektroden von entlang unterschiedlichen Zeilen angeordneten MOS-Transistoren bilden. Schließlich wird eine Source/Drain-Implantation durchgeführt, bei der die Wort leitungen als Maske verwendet werden und bei der gleichzeitig die Source/Drain-Gebiete für die MOS-Transistoren, die am Boden der Langsgraben angeordnet sind und für die MOS-Transistoren, die zwischen benachbarten Langsgraben angeordnet sind, gebildet werden.

Vorzugsweise werden die Langsgraben unter Verwendung einer SiO₂-enthaltenden Grabenmaske als Ätzmaske geätzt. Die Grabenmaske wird anschließend zur Maskierung der Bereiche zwischen benachbarten Längsgräben bei der zweiten Kanalimplantation verwendet. Nach der zweiten Kanalimplantation wird die Grabenmaske entfernt.

Im folgenden wird die Erfindung anhand eines Ausführungsbeispiels und der Figuren näher erläutert.
- Figur 1: zeigt ein Siliziumsubstrat nach einer ersten Kanalimplantation.
- Figur 2: zeigt das Siliziumsubstrat nach einer Grabenätzung und einer zweiten Kanalimplantation.
- Figur 3: zeigt das Siliziumsubstrat nach Bildung von Wortleitungen.
- Figur 4: zeigt den in Figur 3 mit IV-IV bezeichneten Schnitt durch das Siliziumsubstrat.
- Figur 5: zeigt den in Figur 3 mit V-V bezeichneten Schnitt durch das Siliziumsubstrat.
- Figur 6: zeigt eine Aufsicht auf das in Figur 3 dargestellte Siliziumsubstrat.

Die Darstellungen in den Figuren sind nicht maßstäblich.

Zur Herstellung einer erfindungsgemäßen Festwert-Speicherzellenanordnung in einem Substrat 1 aus zum Beispiel monokristallinem Silizium wird zunächst an einer Hauptflache 2 des Substrats 1 eine Isolationsstruktur erzeugt, die den Bereich für die Festwert-Speicherzellenanordnung definiert (nicht dargestellt). Das Substrat 1 ist zum Beispiel p-dotiert mit einer Dotierstoffkonzentration von 10¹⁵ cm⁻³.

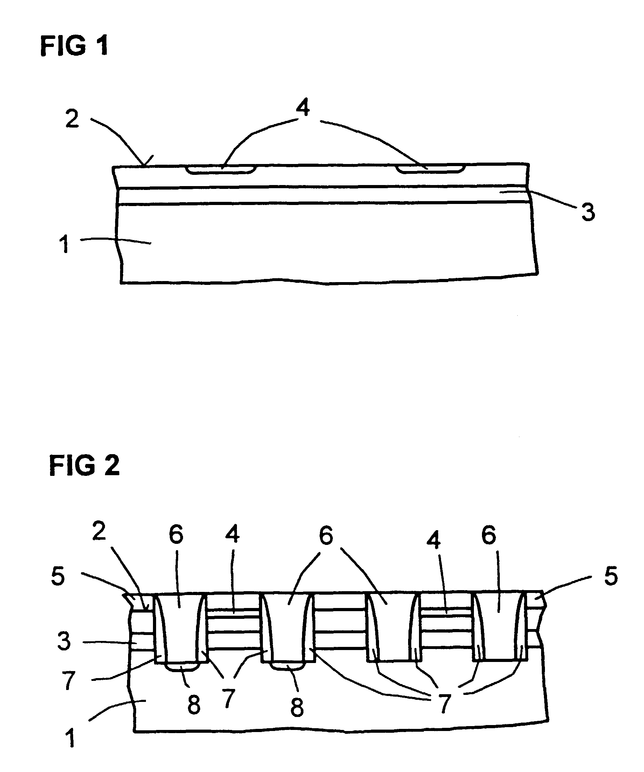

Anschließend wird eine Implantation mit Bor durchgeführt, zur Bildung einer Channel-Stop-Schicht 3. Die Borimplantation erfolgt mit einer Dosis von zum Beispiel 6 x 10¹³ cm⁻² und einer Energie von zum Beispiel 120 keV. Dadurch wird die Channel-Stop-Schicht 3 in einer Tiefe von zum Beispiel 0,3 µm unterhalb der Hauptfläche 2 in einer Dicke von 0,3 µm hergestellt (siehe Figur 1).

Mit Hilfe eines photolithographischen Verfahrens werden dann Bereiche für Depletion-Kanäle von MOS-Transistoren definiert. Mit Hilfe einer ersten Kanalimplantation mit Arsen mit einer Energie von 50 keV und einer Dosis von 4 x 10¹² cm⁻² werden die Depletion-Kanäle 4 gebildet. Die Ausdehnung der Depletion-Kanäle 4 parallel zur Hauptflache 2 beträgt bei Verwendung einer 0,4 µm-Technologie zum Beispiel 0,6 µm x 0,6 µm.

Durch Abscheidung einer SiO₂-Schicht in einer Dicke von zum Beispiel 200 nm mit Hilfe eines TEOS-Verfahrens wird durch Strukturierung der SiO₂-Schicht mit Hilfe photolithographischer Verfahren eine Grabenmaske 5 gebildet (siehe Figur 2).

Durch anisotropes Ätzen zum Beispiel mit Cl₂ werden unter Verwendung der Grabenmaske 5 als Ätzmaske Langsgraben 6 geätzt. Die Längsgraben 6 weisen eine Tiefe von zum Beispiel 0,6 µm auf. Die Längsgraben 6 reichen bis in das Substrat 1 hinein, sie durchtrennen die Channel-Stop-Schicht 3. Die Breite der Depletion-Kanäle 4 wird bei der Ätzung der Längsgräben 6 eingestellt. Daher ist die Justierung der Grabenmaske 5 relativ zu den Depletion-Kanälen 4 unkritisch.

Die Weite der Langsgraben 6 beträgt bei einer 0,4 µm-Technologie 0,4 µm, der Abstand benachbarter Längskanäle 6 beträgt ebenfalls 0,4 µm. Die Länge der Langsgraben 6 richtet sich nach der Größe der Speicherzellenanordnung und beträgt zum Beispiel 130 µm.

Durch Abscheidung einer weiteren SiO₂-Schicht in einem TEOS-Verfahren und anschließendes anisotropes Ätzen werden an den Seitenwänden der Längsgraben 6 Spacer 7 aus SiO₂ gebildet. Mit Hilfe eines photolithographischen Verfahrens werden anschließend Bereiche für die Depletionkanäle für MOS-Transistoren, die nachfolgend am Boden der Längsgraben 6 hergestellt werden, definiert. Mit einer zweiten Kanalimplantation mit zum Beispiel Arsen und einer Energie von zum Beispiel 50 keV und einer Dosis von zum Beispiel 4 x 10¹² cm⁻² werden wie die Depletionkanäle 8 am Boden der Langsgraben erzeugt. Die Bereiche zwischen benachbarten Langsgraben 6 sind dabei durch die Grabenmaske 5 und die Spacer 7 maskiert. Die Justierung bei der Definition der Depletionkanäle 8 ist daher unkritisch. Bezüglich der Seitenwände der Langsgraben 6 ist die zweite Kanalimplantation selbstjustiert.

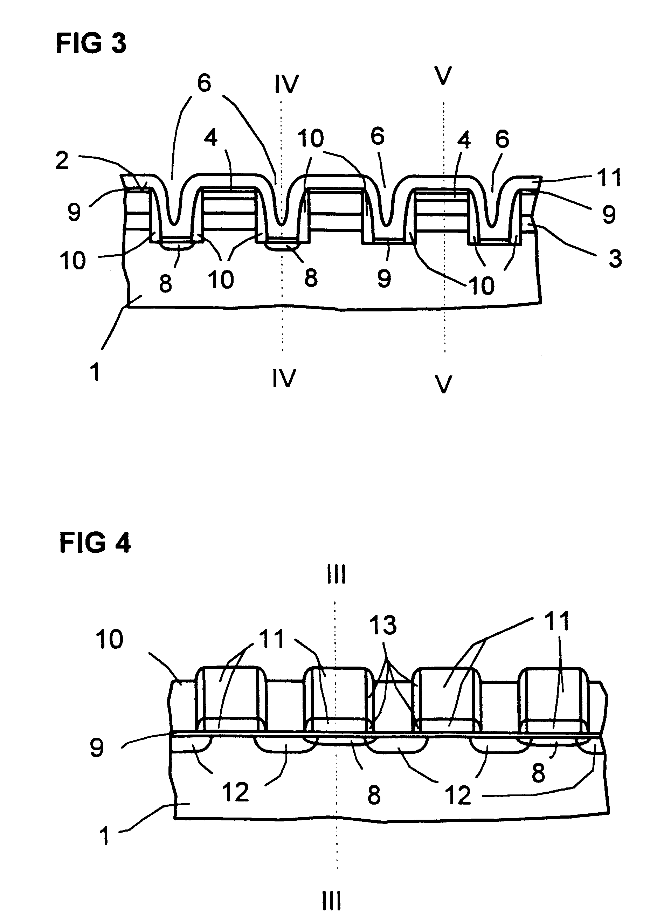

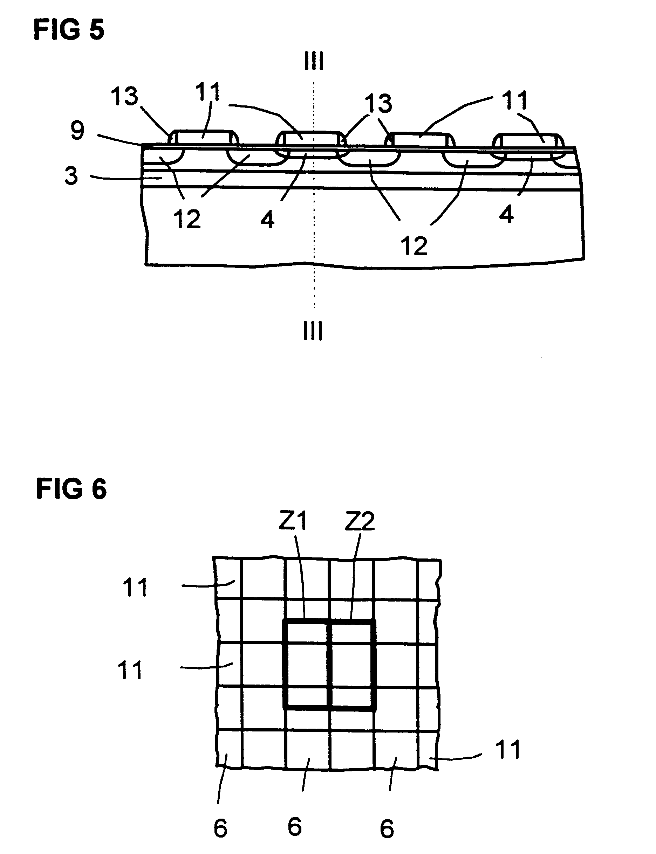

Anschließend wird die Grabenmaske 5 naßchemisch zum Beispiel mit NH₄F/HF entfernt. Dabei werden auch die Spacer 7 entfernt. Nach Aufwachsen und Wegätzen eines Sacrificial-Oxids wird eine Gateoxidschicht 9 in einer Dicke von zum Beispiel 10 nm aufgewachsen. Die Gateoxidschicht 9 ist am Boden der Langsgraben 6 und zwischen den Langsgraben 6 auf der Hauptfläche 2 angeordnet (siehe Figur 3, Figur 4, der den mit IV-IV bezeichneten Schnitt durch Figur 3 darstellt, und Figur 5, die den mit V-V bezeichneten Schnitt in Figur 3 darstellt. Der in Figur 3 dargestellte Schnitt ist in Figur 4 und Figur 5 jeweils mit III-III bezeichnet).

In einem TEOS-Verfahren wird eine weitere SiO₂-Schicht abgeschieden, aus der durch anisotropes Trockenätzen an den Seitenwänden der Längsgräben 6 wiederum Spacer 10 aus SiO₂ gebildet werden. Die SiO₂-Schicht wird in einer Dicke von zum Beispiel 60 nm abgeschieden. Das Rückätzen erfolgt zum Beispiel mit CF₄.

Es wird ganzflächig eine Polysiliziumschicht in einer Dicke von zum Beispiel 400 nm abgeschieden. Durch Strukturierung der Polysiliziumschicht in einem photolithographischen Prozeßschritt werden Wortleitungen 11 gebildet, die entlang der Hauptfläche 2 zum Beispiel senkrecht zu den Längsgraben 6 verlaufen. Die Wortleitungen 11 weisen eine Breite von 0,4 µm auf. Benachbarte Wortleitungen 11 weisen einen Abstand von 0,4 µm auf. Breite und Abstand der Wortleitungen 11 entspricht jeweils einer minimalen Strukturgröße 11. Die Wortleitungen 11 verlaufen so, daß am Boden der Langsgraben 6 gebildete Depletion-Kanäle 8 jeweils unterhalb einer Wortleitung 11 angeordnet sind.

Anschließend wird eine Source/Drain-Implantation mit zum Beispiel Arsen bei einer Energie von zum Beispiel 25 keV und einer Dosis von zum Beispiel 5 x 10¹⁵ cm⁻² durchgeführt. Bei der Source/Drain-Implantation werden am Boden der Langsgraben 6 sowie in der Hauptfläche 2 zwischen den Langsgraben 6 dotierte Gebiete 12 erzeugt. Die dotierten Gebiete 12 wirken jeweils als gemeinsames Source/Drain-Gebiet für zwei entlang einer Zeile angeordnete, benachbarte MOS-Transistoren. Bei der Source/Drain-Implantation werden gleichzeitig die Wortleitungen 11 dotiert.

Durch Abscheiden und anisotropes Rückätzen einer weiteren SiO₂-Schicht werden die Flanken der Wortleitungen 11 mit Spacern 13 bedeckt. Die Source/Drain-Implantation erfolgt selbstjustiert bezüglich der Wortleitungen 11. Da die dotierten Gebiete 12 vom gleichen Leitfähigkeitstyp wie die Depletion-Kanäle 4, 8 dotiert werden, ist die Justierung bei der Definition der Depletion-Kanäle in der Richtung parallel zum Verlauf der Längsgraben 6 unkritisch. Entsprechend dem Abstand benachbarter Wortleitungen 11, dem Abstand benachbarter Langsgraben 6 sowie den Abmessungen der Langsgraben 6 beträgt die Fläche der dotierten Gebiete 12 parallel zur Hauptfläche 2 maximal F x F das heißt 0,4 µm x 0,4 µm. Je zwei benachbarte dotierte Gebiete 12 und die dazwischen angeordnete Wortleitung 11 bilden jeweils einen MOS-Transistor. Am Boden der Längsgraben 6 sowie zwischen den Längsgraben 6 ist jeweils eine Zeile von in Reihe verschalteten MOS-Transistoren, die jeweils aus zwei dotierten Gebieten 12 und der dazwischen angeordneten Wortleitung 11 gebildet sind, angeordnet. Die am Boden eines Längsgrabens 6 angeordneten MOS-Transistoren sind von den benachbarten, zwischen den Längsgräben 6 angeordneten MOS-Transistoren durch den Spacer 10 und die Channel-Stop-Schicht 3 isoliert. Die Dotierung der Channel-Stop-Schicht 3 von zum Beispiel 3 x 10¹⁸ cm⁻³ gewährleistet gemeinsam mit den Spacern 10, daß die Schwellenspannung des an den Flanken der Langsgraben 6 gebildeten, parasitären MOS-Transistoren ausreichend hoch ist, um einen Leckstrom zu unterbinden.

Jede Zeile ist am Rand der Festwert-Speicherzellenanordnung mit zwei Anschlüssen versehen, zwischen denen die in der Zeile angeordneten MOS-Transistoren in Reihe verschaltet sind (nicht dargestellt).

Berücksichtigt man, daß jedes der dotierten Gebiete 12 Source/Drain-Gebiet für zwei angrenzende MOS-Transistoren ist, so beträgt die Länge jedes MOS-Transistors parallel zum Verlauf der Langsgraben 6 2F. Die Breite der MOS-Transistoren beträgt jeweils F. Herstellungsbedingt beträgt die Fläche für eine aus einem MOS-Transistor gebildete Speicherzelle daher 2 F². Entlang einer Wort leitung 11 benachbarte Speicherzellen, deren Konturen Z1, Z2 in der Aufsicht in Figur 6 als verstärkte Linie eingezeichnet sind, grenzen in der Projektion auf die Hauptfläche 2 unmittelbar aneinander. Die Speicherzelle Z1 ist am Boden eines der Langsgraben 6 angeordnet, die Speicherzelle Z2 dagegen auf der Hauptflache 2 zwischen zwei benachbarten Langsgraben 6. Durch die in der Höhe versetzte Anordnung benachbarter Speicherzellen wird die Packungsdichte erhöht, ohne daß die Isolation zwischen benachbarten Speicherzellen verschlechtert würde.

Die Programmierung der Festwert-Speicherzellenanordnung erfolgt bei der ersten Kanalimplantation und der zweiten Kanalimplantation. Die Depletion-Kanäle 4, 8 werden nur für diejenigen MOS-Transistoren gebildet, denen ein erster logischer Wert zugeordnet wird. Den anderen MOS-Transistoren wird ein zweiter logischer Wert zugeordnet.

Die Festwert-Speicherzellenanordnung wird durch Abscheidung eines Zwischenoxids, Kontaktlochätzungen und Aufbringen und Strukturieren einer Metallschicht fertiggestellt. Diese bekannten Prozeßschritte sind nicht dargestellt.

## Patentansprüche

1. Festwert-Speicherzellenanordnung,
- bei der eine Vielzahl einzelner Speicherzellen in einem Halbleitersubstrat (1) vorgesehen sind,
- bei der die Speicherzellen jeweils in im wesentlichen parallel verlaufenden Zeilen angeordnet sind,
- bei der in einer Hauptfläche (2) des Halbleitersubstrats (1) Langsgraben (6) vorgesehen sind, die im wesentlichen parallel zu den Zeilen verlaufen,
- bei der die Zeilen jeweils abwechselnd auf der Hauptflache (2) zwischen benachbarten Längsgräben (6) und auf dem Boden der Längsgräben (6) angeordnet sind,
- bei der Isolationsstrukturen (3, 10) vorgesehen sind, die benachbarten Zeilen der Speicherzellen gegeneinander isolieren,
- bei der die Speicherzellen jeweils mindestens einen MOS-Transistor (12, 11, 12), dessen Kanallänge parallel zu den Zeilen ausgerichtet ist, umfassen,
- bei der quer zu den Zeilen Wortleitungen (11) verlaufen, die jeweils mit den Gateelektroden von entlang unterschiedlichen Zeilen angeordneten MOS-Transistoren verbunden sind.

2. Festwert-Speicherzellenanordnung nach Anspruch 1,
bei der die Isolationsstrukturen zur Isolation benachbarter Zeilen der Speicherzellen entlang den Seitenwänden der Längsgräben (6) angeordnete, isolierende Spacer (10) und jeweils zwischen benachbarten Längsgraben (6) im Halbleitersubstrat (1) angeordnete, dotierte Schichten (3) umfassen, die die Ausbildung leitender Kanäle im Halbleitersubstrat (1) zwischen benachbarten Zeilen der Speicherzellen verhindern.

3. Festwert-Speicherzellenanordnung nach Anspruch 1 oder 2,
- bei der die MOS-Transistoren von entlang einer Zeile angeordneten Speicherzellen in Reihe verschaltet sind,
- bei der miteinander verbundene Source/Drain-Gebiete von entlang einer Zeile benachbarten MOS-Transistoren als zusammenhängendes dotiertes Gebiet (12) im Halbleitersubstrat ausgebildet sind,
- bei der jede Zeile zwei Anschlüsse aufweist, zwischen denen die in der Zeile angeordneten MOS-Transistoren in Reihe verschaltet sind.

4. Festwert-Speicherzellenanordnung nach einem der Ansprüche 1 bis 3,
bei der die MOS-Transistoren je nach in der jeweiligen Speicherzelle eingespeicherter Information unterschiedliche Schwellenspannungen aufweisen.

5. Verfahren zur Herstellung einer Festwert-Speicherzellenanordnung,
- bei dem in einer Hauptfläche (2) eines Halbleitersubstrats (1) im wesentlichen parallel verlaufende Längsgräben (6) geätzt werden,
- bei dem eine Vielzahl in Zeilen angeordneter Speiche§zellen, die jeweils mindestens einen MOS-Transistor, dessen Kanallänge parallel zu den Zeilen ausgerichtet ist, umfassen, erzeugt werden, wobei die Zeilen abwechselnd an der Hauptfläche (2) zwischen benachbarten Langsgraben (6) und am Boden der Langsgraben (6) angeordnet sind,
- bei dem vor der Ätzung der Langsgraben (6) eine erste Kanalimplantation zur Einstellung der Schwellenspannungen der MOS-Transistoren, die an der Hauptfläche (2) zwischen benachbarten Längsgräben (6) angeordnet sind, durchgeführt wird,
- bei dem nach der Ätzung der Langsgraben (6) eine zweite Kanalimplantation zur Einstellung der Schwellenspannungen der MOS-Transistoren, die am Boden der Langsgraben (6) angeordnet sind, durchgeführt wird,
- bei dem die Hauptfläche (2) zwischen benachbarten Längsgräben (6) maskiert ist,
- bei dem eine Gateoxidschicht erzeugt wird,
- bei dem quer zu den Zeilen verlaufende Wortleitungen (11) erzeugt werden, die jeweils mit Gateelektroden von entlang unterschiedlichen Zeilen angeordneten MOS-Transistoren verbunden sind,
- bei dem eine Source/Drain-Implantation für die MOS-Transistoren durchgeführt wird, bei der die Wortleitungen (11) als Maske verwendet werden,
- bei dem Isolationsstrukturen (3, 10) erzeugt werden, die die MOS-Transistoren benachbarter Zeilen gegeneinander isolieren.

6. Verfahren nach Anspruch 5,
- bei dem zur Bildung der Isolationsstrukturen vor der ersten Kanalimplantation eine dotierte Schicht (3) im Halbleitersubstrat erzeugt wird, die beim Ätzen der Langsgraben (6) durchätzt wird und die die Ausbildung leitender Kanäle im Halbleitersubstrat (1) zwischen benachbarten Zeilen der Speicherzellen verhindert,
- bei dem zur Bildung der Isolationsstrukturen (3, 10) ferner nach dem Ätzen der Langsgraben (6) an den Seitenwänden der Langsgraben (6) isolierende Spacer (10) erzeugt werden.

7. Verfahren nach Anspruch 5,
- bei dem die Ätzung der Langsgraben (6) unter Verwendung einer SiO₂-enthaltenden Grabenmaske (5) als Ätzmaske erfolgt,
- bei dem die SiO₂-enthaltende Grabenmaske (5) bei der zweiten Kanalimplantation die Hauptfläche (2) zwischen benachbarten Langsgraben (6) maskiert,
- bei dem die Grabenmaske (5) nach der Kanalimplantation entfernt wird.

## Claims

1. Read-only memory cell array,
- in which a plurality of individual memory cells are provided in a semiconductor substrate (1),
- in which the memory cells are each arranged in rows running essentially parallel,
- in which longitudinal trenches (6) which run essentially parallel to the rows are provided in a main surface (2) of the semiconductor substrate (1),
- in which the rows are arranged alternately on the main surface (2) between adjacent longitudinal trenches (6) and at the bottom of the longitudinal trenches (6) respectively,
- in which insulation structures (3, 10) are provided which insulate adjacent rows of the memory cells with respect to one another,
- in which the memory cells each comprise at least one MOS transistor (12, 11, 12) whose channel length is aligned parallel to the rows,
- in which word lines (11) which are connected in each case to the gate electrodes of MOS transistors which are arranged along different rows run transversely with respect to the rows of the memory cells.

2. Read-only memory cell array according to Claim 1, in which, for the insulation of adjacent rows of the memory cells, the insulation structures comprise insulating spacers (10) which are arranged along the sidewalls of the longitudinal trenches (6) and doped layers (3) which are arranged in each case between adjacent longitudinal trenches (6) in the semiconductor substrate (1) and prevent the formation of conductive channels in the semiconductor substrate (1) between adjacent rows of the memory cells.

3. Read-only memory cell array according to Claim 1 or 2,
- in which the MOS transistors of memory cells arranged along one row are connected in series,
- in which source/drain regions, connected to one another, of MOS transistors which are adjacent along one row are constructed as a continuous doped region (12) in the semiconductor substrate,
- in which each row has two connections, between which connections the MOS transistors which are arranged in the row are connected in series.

4. Read-only memory cell array according to one of Claims 1 to 3, in which the MOS transistors have different threshold voltages depending on the information stored in the respective memory cell.

5. Process for manufacturing a read-only memory cell array,
- in which longitudinal trenches (6) which run essentially parallel are etched in one main surface (2) of a semiconductor substrate (1),
- in which a plurality of memory cells which are arranged in rows and which each comprise at least one MOS transistor, whose channel length is aligned parallel to the rows, are produced, the rows being arranged alternately on the main surface (2) between adjacent longitudinal trenches (6) and at the bottom of the longitudinal trenches (6),
- in which, before the etching of the longitudinal trenches (6), a first channel implantation is made in order to set the threshold voltages of the MOS transistors which are arranged on the main surface (2) between adjacent longitudinal trenches (6),
- in which, after the etching of the longitudinal trenches (6), a second channel implantation is made in order to set the threshold voltages of the MOS transistors which are arranged at the bottom of the longitudinal trenches (6),
- in which the main surface (2) between adjacent longitudinal trenches (6) is masked,
- in which a gate oxide layer is produced,
- in which word lines (11) which run transversely with respect to the rows are produced, which word lines (11) are connected in each case to gate electrodes of MOS transistors which are arranged along different rows,
- in which a source/drain implantation for the MOS transistors is made, during which the word lines (11) are used as a mask,
- in which insulation structures (3, 10) are produced which insulate the MOS transistors of adjacent rows with respect to one another.

6. Process according to Claim 5,
- in which, in order to form the insulation structures, a doped layer (3) is produced in the semiconductor substrate before the first channel implantation, which doped layer (3) is etched through during the etching of the longitudinal trenches (6) and prevents the formation of conductive channels in the semiconductor substrate (1) between adjacent rows of the memory cells,
- in which, in order to form the insulation structures (3, 10), insulating spacers (10) are also produced on the sidewalls of the longitudinal trenches (6) after the etching of the longitudinal trenches (6).

7. Process according to Claim 5,
- in which the etching of the longitudinal trenches (6) takes place using a trench mask (5) containing SiO₂ as etching mask,
- in which, during the second channel implantation, the trench mask (5) which contains SiO₂ masks the main surface (2) between adjacent longitudinal trenches (6),
- in which the trench mask (5) is removed after the channel implantation.

## Revendications

1. Système de cellules de mémoire morte,
- dans lequel un substrat semiconducteur (1) contient une pluralité de cellules de mémoire individuelles,
- dans lequel les cellules de mémoire sont disposées à chaque fois en rangées s'étendant essentiellement parallèlement,
- dans lequel une surface principale (2) du substrat semiconducteur (1) est pourvue de tranchées longitudinales (6) qui s'étendent essentiellement parallèlement aux rangées,
- dans lequel les rangées sont à chaque fois disposées alternativement sur la surface principale (2) entre tranchées longitudinales (6) contiguës et sur le fond des tranchées longitudinales (6),
- dans lequel des structures d'isolation (3, 10) sont prévues, qui isolent l'une de l'autre les rangées contiguës des cellules de mémoire,
- dans lequel les cellules de mémoire contiennent à chaque fois au moins un transistor MOS (12, 11, 12) dont la longueur de canal est orientée parallèlement aux rangées,
- dans lequel des lignes de mot (11) s'étendent transversalement aux rangées, qui sont connectées à chaque fois aux électrodes de grille de transistors MOS disposés le long de différentes rangées.

2. Système de cellules de mémoire morte selon la revendication 1, dans lequel les structures d'isolation destinées à isoler les rangées contiguës des cellules de mémoire comprennent des écarteurs (10) isolants disposés le long des parois latérales des tranchées longitudinales (6) et des couches dopées (3) disposées à chaque fois entre tranchées longitudinales (6) contiguës dans le substrat semiconducteur (1), qui empêchent la formation de canaux conducteurs dans le substrat semiconducteur (1) entre les rangées contiguës des cellules de mémoire.

3. Système de cellules de mémoire morte selon la revendication 1 ou 2,
- dans lequel les transistors MOS de cellules de mémoire disposées le long d'une rangée sont montés en série,
- dans lequel des zones source-drain interconnectées de transistors MOS contigus le long d'une rangée, sont réalisées sous forme de zone dopée (12) continue dans le substrat semiconducteur,
- dans lequel chaque rangée comporte deux connexions, entre lesquelles les transistors MOS disposés dans la rangée sont montés en série.

4. Système de cellules de mémoire morte selon l'une des revendications 1 à 3, dans lequel les transistors MOS présentent des tensions de seuil variables en fonction de l'information stockée dans la cellule de mémoire respective.

5. Procédé de réalisation d'un système de cellules de mémoire morte,
- dans lequel on réalise par attaque chimique, dans une surface principale (2) d'un substrat semiconducteur (1), des tranchées longitudinales (6) s'étendant essentiellement parallèlement,
- dans lequel on crée une pluralité de cellules de mémoire disposées en rangées, qui comportent à chaque fois au moins un transistor MOS dont la longueur de canal est orientée parallèlement aux rangées, les rangées étant disposées alternativement à la surface principale (2) entre tranchées longitudinales (6) contiguës et au fond des tranchées longitudinales (6),
- dans lequel, avant réalisation par attaque chimique des tranchées longitudinales (6), on effectue une première implantation de canal pour régler les tensions de seuil des transistors MOS disposés à la surface principale (2) entre tranchées longitudinales (6) contiguës,
- dans lequel, après réalisation par attaque chimique des tranchées longitudinales (6), on effectue une deuxième implantation de canal pour régler les tensions de seuil des transistors MOS disposés au fond des tranchées longitudinales (6),
- dans lequel la surface principale (2) entre tranchées longitudinales (6) contiguës est masquée,
- dans lequel on crée une couche d'oxyde de grille,
- dans lequel on crée des lignes de mot (11) s'étendant transversalement aux rangées, qui sont connectées à chaque fois à des électrodes de grille de transistors MOS disposés le long de différentes rangées,
- dans lequel on effectue une implantation source-drain pour les transistors MOS, en utilisant les lignes de mot (11) comme masque,
- dans lequel on crée des structures d'isolation (3, 10) qui isolent l'un de l'autre les transistors MOS de rangées contiguës.

6. Procédé selon la revendication 5,
- dans lequel, pour former les structures d'isolation, on crée avant la première implantation de canal, dans le substrat semiconducteur, une couche dopée (3) qui est fendue lors de la réalisation des tranchées longitudinales (6) par attaque chimique et qui empêche la formation de canaux conducteurs dans le substrat semiconducteur (1) entre les rangées contiguës des cellules de mémoire,
- dans lequel, pour former les structures d'isolation (3, 10), on crée en outre, après la réalisation par attaque chimique des tranchées longitudinales (6), des écarteurs (10) isolants sur les parois latérales des tranchées longitudinales (6).

7. Procédé selon la revendication 5,
- dans lequel on utilise pour la réalisation des tranchées longitudinales (6) par attaque chimique, comme masque d'attaque, un masque de tranchée (5) contenant du SiO₂,
- dans lequel, lors de la deuxième implantation de canal, le masque de tranchée (5) contenant du SiO₂ masque la surface principale (2) entre tranchées longitudinales (6) contiguës,
- dans lequel on supprime le masque de tranchée (5) après l'implantation de canal.
